(19) Europäisches Patentamt

European Patent Office

Office européen des brevets

(11) **EP 0 736 109 B1**

(12) **EUROPÄISCHE PATENTSCHRIFT**

(45) Veröffentlichungstag und Bekanntmachung des Hinweises auf die Patenterteilung:
**05.07.2000 Patentblatt 2000/27**

(21) Anmeldenummer: **95905080.8**

(22) Anmeldetag: **19.12.1994**

(51) Int. Cl.[7]: **C23C 14/06**, C01B 21/082,
C03C 3/32, F24J 2/00

(86) Internationale Anmeldenummer:
**PCT/EP94/04213**

(87) Internationale Veröffentlichungsnummer:
**WO 95/17533 (29.06.1995 Gazette 1995/27)**

(54) **MATERIAL AUS CHEMISCHEN VERBINDUNGEN MIT EINEM METALL DER GRUPPE IV A DES PERIODENSYSTEMS, STICKSTOFF UND SAUERSTOFF UND VERFAHREN ZU DESSEN HERSTELLUNG**

MATERIAL OF CHEMICAL COMPOUNDS WITH A METAL IN GROUP IV A OF THE PERIODIC SYSTEM, NITROGEN AND OXYGEN AND PROCESS FOR PRODUCING IT

MATERIAU REALISE A PARTIR DE COMPOSES CHIMIQUES COMPORTANT UN METAL DU GROUPE IV DE LA CLASSIFICATION PERIODIQUE DES ELEMENTS, D'AZOTE ET D'OXYGENE ET SON PROCEDE DE PRODUCTION

(84) Benannte Vertragsstaaten:
**AT DK ES FR GB GR IT NL SE**

(30) Priorität: **23.12.1993 DE 4344258**

(43) Veröffentlichungstag der Anmeldung:
**09.10.1996 Patentblatt 1996/41**

(73) Patentinhaber:
• **Mayer, Isabella**
**80797 München (DE)**
• **Lazarov, Miladin P.**
**80797 München (DE)**

(72) Erfinder: **LAZAROV, Miladin, P.**
**D-80797 München (DE)**

(74) Vertreter:
**Dost, Wolfgang, Dr. rer.nat., Dipl.-Chem. et al
Bardehle, Pagenberg & Partner,
Galileiplatz 1
81679 München (DE)**

(56) Entgegenhaltungen:
**EP-A- 0 488 180        EP-A- 0 564 709
DE-A- 3 522 427**

• **OPTICAL MATERIALS TECHNOLOGY FOR ENERGY EFFICIENCY AND SOLAR ENERGY CONVERSION XII, PROC. SPIE 2017, 1993 WASHINGTON/USA, Seiten 345-356, LAZAROV ET AL. 'Optimization of SiO2-TiNxOy-Cu Interference Absorbers: Numerical and Experimental Results' in der Anmeldung erwähnt**
• **THIN SOLID FILMS, Bd. 223,Nr. 12, 15.Februar 1993 LAUSANNE CH, Seiten 288-292, ATANASSOV ET AL. 'Optical Properties of TiO2, Y2O3 and CeO2 thin films deposited vy electron beam evaporation'**

EP 0 736 109 B1

## Beschreibung

Die Erfindung betrifft ein Material nach Patentanspruch 1 sowie die Verwendung des Materials nach Patentanspruch 9 und ein Verfahren zur Herstellung des Materials nach Patentanspruch 11.

Verbindungen von Titan mit Stickstoff und Sauerstoff decken eine breite Palette der bekannten Stoffeigenschaften ab und finden daher einen weiten industriellen Einsatz. Titandioxid, zum Beispiel, ist ein Hauptbestandteil der weissen Wandfarben, wird aber auch in Solarzellen eingesetzt. Die Verbindung TiN ist als elektrisch leitende Keramik bekannt und zeichnet sich durch hohe Widerstandsfähigkeit und Härte aus. Werkzeuge werden damit gehärtet, und in der Halbleiterindustrie findet diese Verbindung ihren Einsatz als Diffusionsbarriere zwischen Silizium und Aluminium. Mischungen aus TiN und Titanoxidphasen sind wenig untersucht. Für den praktischen Einsatz wären Materialien, die beide Eigenschaften, dielektrisch und metallisch, in sich vereinigen, sehr reizvoll.

Die Autoren der Offenlegunsschrift **DE 35 22 427 A1** offenbaren ein Material aus Titan und Stickstoff, dessen elektrische Eigenschaften durch Beimischung von Sauerstoff verschiedenen Anwendungen angepaßt werden. Dies führt dazu, daß die chemische Zusammensetzung verändert wird und andere physikalische und chemische Eigenschaften, wie zum Beispiel Haftfestigkeit, Korrosionsbeständigkeit, Temperaturbeständigkeit oder Härte nachteilig beeinflußt werden. Besonders nachteilig dabei ist, daß dieses Material zu Oxidation neigt, wenn es Sauerstoff ausgesetzt wird. Da aber gerade der Anteil an Sauerstoff die gewünschten Eigenschaften determiniert, werden sich diese mit der Zeit ändern, was einem praktischen Einsatz entgegensteht.

In der US-Patentschrift von Blickensderfer et al. **US 4,098,956** wird ein selektiver Absorber offenbart, der mit $TiN_xO_y$ beschichtet ist. Die Autoren berichten von Anteilen an Sauerstoff und Kohlenstoff in der Beschichtung. Leerräume als entscheidendes Merkmal werden nicht erwähnt und sind den Autoren als für die Anwendung wesentliche Eigenschaften nicht bekannt. Der Gegenstand der **US 4,098,956** hat den Nachteil, daß die optischen Materialeigenschaften nur über Variation der chemischen Zusammensetzung verschiedenen Anforderungen angepaßt werden können. Diese notwendigen Änderungen der chemischen Zusammensetzung bewirken, daß andere notwendige Eigenschaften, wie z.B. Haftfestigkeit, verloren gehen. Von diesen Nachteilen berichten die Autoren in einer anderen Veröffentlichung: **R. Blickensderfer D.K. Deardorff, R.L. Lincoln, "Spectral reflectance of $TiN_x$ and $ZrN_x$ films as selective solar absorbers", Solar Energy, Band 19, Seiten 429-432, 1977,** wo Probleme mit der Degradation bei solchen Materialien beschrieben werden.

Neben vielen Untersuchungen über TiN (siehe z.B. **DE-OS-32 104 20** oder **DE-OS-33 006 94**) und Titandioxid (siehe z.B. **DE-OS-31 166 77**), wurde Titanoxynitrid ($TiN_xO_y$) von Vogelzang et al. (**E. Vogelzang, J. Sjollema, H.J. Boer, J.Th.M. DeHosson, "Optical absorption in $TiN_xO_y$-compounds", J.Appl. Phys. 61 (9), S. 4606-4611,1987**) untersucht. In der zitierten Arbeit wird neben anderen Messgrößen die komplexwertige Dielektrizitätskontante e ($\lambda$) als Funktion der Wellenlänge $\lambda$ im Bereich von 0.4 bis 30 $\mu$m veröffentlicht. Berechnet man mit diesen veröffentlichten Werten und der Fresneltheorie den Reflexions- und Transmissionsgrad, so stimmen die Rechnungen nicht mit den Ergebnissen überein, welche die Autoren in der gleichen Arbeit selbst veröffentlichen. Es ist daher anzunehmen, daß bei der Bestimmung von e ($\lambda$) ein Fehler unterlaufen ist. Damit ist auch die in dieser Arbeit aufgeführte Erklärung des optischen und dielektrischen Verhaltens hinfällig und damit eine praktische Umsetzung nicht möglich.

In der Offenlegungsschrift **DE 36 40 086 A1** werden Verbindungen von Titan, Stickstoff, Sauerstoff und Kohlenstoff offenbart. Alls Merkmal wird gefordert, daß der Sauerstoff anteil höher ist als der Stickstoff- oder Kohlenstoffanteil. Auch hier jedoch wird nicht auf einen Leerraumanteil eingegangen.

In der Offenlegungsschrift **DE 36 37 810 A1** wird die Herstellung eines Material, offenbart, welches Titan, Stickstoff und Kohlenstoff enthält. Es ist bekannt, daß durch die angewendete Ionenplattierung dichte Schichten entstehen. Es ist daher davon auszugehen, daß Leerräume in diesen Schichten fehlen.

Materialien mit Leerräumen (engl. Voids) werden in der Literatur öfters beschrieben, z.B. für dünne Schichten aus TiN (siehe z.B. **P.J. Martin, R.P. Netterfield und W.G. Sainty, "Optical Properties of $TiN_x$ Produced by Reactive Evaporation and Reactive Ion - Beam Sputtering", Vacuum Band 32 (1982), Seiten 359-362** oder **DE 42 07 368 A1**), besonders Schellinger et al. über $TiN_xO_y$ (**H.Schellinger, M. Lazarov, H. Klank, R. Sizmann, "Thermal and Chemical Metallic-Dielectric Transitions of** $TiN_xO_y$-Cu **Absorber Tandems", Proc. SPIE 2017 "Optical Materials Technology for Energy Efficiency and Solar Energy Conversion XII", 1993 Seiten 345-356).** Alle bisherigen Autoren berichten über die blosse Existenz von Leerräumen. Die Quantifizierung der Leerräume wurde bisher nicht vollzogen.

In der Patentschrift **DE 22 16 432 C3** wird über Titandioxid mit offener Porösität berichtet. Die dort beschriebenen Leerräume (Poren) haben sehr große Volumina.

Optische und elektrische Eigenschaften von Materialien können in dielektrische und metallische eingeteilt werden, wonach sich der Einsatz der Materialien entscheidet. Bei vielen Anwendungen sind jedoch Mischungen aus beiden Eigenschaften gefragt. Bei einem Absorber-Reflektor-Tandem (siehe z.B. **DE 26 39 388 C 2** oder **DE 27 34 544 C 2**) kann weder ein reines Metall noch ein Dielektrikum eine für Sonnenstrahlen selektive Absorption liefern. Halbleiter mit und ohne Dotierung leisten teilweise solche Anforderungen und finden ihren Einsatz bei vielerlei Anwendungen.

Denkt man an einen selektiven Absorber, ist die feste Bandlücke und die relativ flache Absorptionskante typisch für einen Halbleiter, hinderlich für hochselektive Eigenschaften.

DE-OS-35 22 427 betrifft die Herstellung von elektrisch leitfähigen Temperatur- und Dehnungsmeß-Sonden, wobei Titanoxynitrid-Schichten durch reaktive Ionenaufdampfung oder Gleichspannungs- oder Hochfrequenzmagnetron-Anstäubung aufgebracht werden.

GB-A-2,186,294 betrifft die Aufbringung eines harten, schwarzfarbigen Dekors aus TiOCN, ZrOCN und/oder HfOCN durch Sputtern auf Uhrenarmbänder oder Brillengestelle.

EP-A-0 564 709 betrifft ein Glassubstrat, auf das ein Schichtsystem aus einer Schicht hochbrechenden Materials und einer Schicht niedrigbrechenden Materials aufgebracht ist. Die Schicht hochbrechenden Materials wird aus einem Oxynitrid des Hafniums, Zirkons, Tantals oder Titans gebildet. Die Aufbringung des Schichtsystems auf das Substrat erfolgt durch Sputtern, wodurch dichte Schichten ohne Leerräume entstehen.

US-4,861,669 betrifft die Herstellung von IR-Reflexions-Schichtstapeln auf Glasträger durch Aufsputtern von hartem, transparentem TiON.

JP-A-57-2875 betrifft die Herstellung farbiger, abrieb- und korrosionsfester Schichten aus $TiN_xO_y$ und $TiO_{z-}C_xN_y$ als Dekor auf z.B. Armbanduhren.

JP-A-63-125 658 betrifft die Dekorbeschichtung von Uhrenteilen mit 0,14 μm Ti-O-N-Verbindungen. Auch die JP-A-63-247 350 beschreibt die Herstellung von Dekorschichten aus Titanoxycarbonitrid.

Die Aufgabe der vorliegenden Erfindung besteht darin, ein Material zur Verfügung zu stellen, das sich für einen breiten Anwendüngsbereich in der Solarenergie und der Kraftwerksindustrie, aber auch als Dekorschicht für verschiedene Zwecke eignet. Das Material soll dabei Eigenschaften haben, die weder rein metallischer noch dielektrischer Natur sind. Weiter besteht die Aufgabe der vorliegenden Erfindung darin, ein Verfahren bereitzustellen, mit dem das Material hergestellt werden kann.

Die Aufgabe wird in der vorliegenden Erfindung durch die Gegenstände der Ansprüche 1, 9 und 11 gelöst. Vorteilhafte Ausgestaltungen sind Gegenstand der Unteransprüche.

Das Material gemäß Anspruch 1 enthält chemische Verbindungen zwischen einem oder mehreren Metallen der Gruppe IV A des Periodensystems, Stickstoff und Sauerstoff, wobei 2 bis 45%, vorzugsweise 5 bis 40%, ganz bevorzugt 10 bis 28% des Volumens durch Leerräume (Voids), deren Größe im Bereich von $(0,5 \text{ nm})^3$ bis $(100 \text{ nm})^3$ liegt, gebildet wird. Das restliche Volumen des Materials (98 - 55%, vorzugsweise 95 -60%) weist eine Zusammensetzung des Metalls der Gruppe IV A des Periodensystems zu Stickstoff zu Sauerstoff wie 1:(0,1 bis 1,7):(0,1 bis 1,7), vorzugsweise 1:(0,25 bis 1,5):(0,25 bis 1,5) auf. Das Material hat die Formel $MN_xO_y$, wobei "M" Metall der Gruppe IV A des Periodensystems bedeutet und $x$ bzw. $y$ die Werte 0, 1 bis 1,7 haben. Die obigen Verhältnisse beziehen sich auf die Teilchenanzahl bzw. Molverhältnisse. Bei den Größen der Leerräume ist es bevorzugt, daß diese in ihrem unteren Bereich, d. h. vorzugsweise bei nicht größer als $(15 \text{ nm})^3$, liegen. Das "restliche Volumen" des Materials umfaßt vorzugsweise eine oder mehrere der chemischen Verbindungen ausgewählt aus $MN_x$ ($x = 0,7$ bis 1,2), $MO_x$ ($x = 0,7$ bis 1,2), Magnelli-Phasen des M-O-Systems ($M_nO_{2n-1}$), $MO_2$, $M_2N$ (mit M = Metall der Gruppe IV A des Periodensystems) sowie ca. 0-30%, vorzugsweise 0,5-5% an Kohlenstoffverbindungen eines Metalls der Gruppe IV A des Periodensystems. Durch diese vorzugsweise zusätzlich enthaltenen Verbindungen wird das Spektrum an wichtigen Einsatzmöglichkeiten erweitert. Geringe Mengen an Titancarbiden als Verunreinigung sind bei vielen Eigenschaften nicht störend, erlauben aber eine billigere Herstellung. Die Möglichkeit, daß im erfindungsgemäßen Material die vorliegenden chemischen Phasen vorzugsweise in kristalliner oder in amorpher Form vorliegen können, erlaubt verschiedene Anwendungsbereiche abzudecken, z. B. in kristalliner Form als Diffusionsbarriere in der Halbleiterindustrie oder in amorpher Form als dekorative Schicht. Das Metall der Gruppe IV A des Periodensystems ist Titan, Zirkonium oder Hafnium oder eine Mischung von zwei oder drei dieser Metalle, vorzugsweise ist es Titan.

Das erfindungsgemäße Material kann weiter dadurch beschrieben werden, daß wenn $\bar{p}$ der Mittelwert der Massendichte der einzelnen chemischen Verbindungen, aus denen das Material zusammengesetzt ist und $p_m$ die Massendichte des Materials inklusiv Leerräumen ist, die Größe

$$\frac{\bar{p} - p_m}{\bar{p}}$$

im Bereich von 0,02 bis 0,5 liegt.

Weiter ist es bevorzugt, daß das erfindungsgemäße Material Leerräume mit einer fraktalen Größenverteilung aufweist. Durch die vorliegende Spezifizierung der Art der Leerräume wird das erfindungsgemäße Material deutlich von Materialien abgegrenzt, deren reduzierte Massendichte auf veränderte Gitterkonstanten und starke Fehlstellendichte zurückzuführen ist. Der definierte Leerraumanteil und die Leerraumverteilung erlauben das erfindungsgemäße Material als Standard bei Neutronenstreuuntersuchungen einzusetzen.

Das erfindungsgemäße Material ist weiterhin vorzugsweise dadurch gekennzeichnet, daß der Realteil der Brechzahl für die Röntgenwellenlänge von 0,0709 nm im Bereich von 0,9999984 bis 0,9999973 liegt. Die Massendichte des erfindungsgemäßen Materials liegt bevorzugt im Bereich von 3,7 bis 4,5 g/cm$^3$, vorzugsweise im Bereich von 3,8 bis 4,2 g/cm$^3$. Durch diese Eigenschaften eignet sich das erfindungsgemäße Material auch zum Einsatz als Standard bei Dichtebestimmungen von dünnen Filmen.

Eine weitere Eigenschaft des erfindungsgemäßen Materials ist, daß die komplexwertige Brechzahl für Wellenlängen im Bereich von 0,5 bis 4,5 µm weder auf ein typisches metallisches Verhalten, noch auf ein typisches dielektrisches Verhalten hinweist. Dadurch eignet sich das Material hervorragend als Strahlungsenergieumwandler. Die Verwendung bei der Umwandlung von Strahlungsenergie in Wärme erfordert optische Eigenschaften im Infraroten, die weder metallisch noch dielektrischer Natur sind. Metallische Eigenschaften lassen sich durch eine Drudetheorie beschreiben, während dielektrische Materialien einen sehr Weinen Imaginärteil der Brechzahl haben. Bei dem erfindungsgemäßen Material zeigen elektronenverlustspektroskopische (EELS) Messungen einen Peak auf, der als eine Plasmawellenlänge $\lambda_p$ im Sinne der Drudetheorie gedeutet werden kann, wobei $\lambda_p$ im Bereich von 1,1 bis 0,1 µm liegt. Diese Plasmawellenlänge korreliert aber nicht mit typisch metallischem Verhalten (beschreibbar durch die Drudetheorie) der optischen Konstanten.

Vorzugsweise liegt das erfindungsgemäße Material als Pulver oder Glas vor. Dies ermöglicht eine Anwendung des Materials im Bereich der volumetrischen Absorber.

Werden Mischungen von Titan-, Zirkonium- oder Hafnium-Verbindungen eingesetzt, erweitert dies den Anwendungsbereich des Materials auf Felder, die hohe Temperaturstabilität erfordern. Verbindungen aus Zirkonium oder Hafnium weisen eine höhere thermische Stabilität auf als Titanverbindungen, ferner sind erstere resistent gegen Diffusionsprozesse.

Das erfindungsgemäße Material kann vorzugsweise als dünne Schicht vorliegen, deren Schichtdicke im Bereich von 3 nm bis 3 mm, vorzugsweise 10 nm bis 2 mm und ganz bevorzugt von 30 bis 71 nm liegt. Dabei weist die dünne Schicht vorzugsweise eine kollumnare Mikrostruktur auf. Dies ermöglicht Anwendungen, bei welchen die Schicht porös und rauh sein soll. Die dünne Schicht aus dem erfindungsgemäßen Material hat einen spezifischen Widerstand in Bereich von 30 bis 30000 µΩ.cm, vorzugsweise 100 bis 6000 µΩ.cm, ganz bevorzugt 2000 bis 3000 µΩ.cm. Diese Eigenschaft legt Anwendungen in der Halbleiterindustrie nah, bei denen jeweils ein anderer spezifischer Widerstand verlangt wird, der Herstellungsprozeß jedoch aus Kostengründen nur leicht verändert werden soll, um diese Eigenschaften zu erfüllen. Der spezifische Widerstand kann durch die Wahl des Leerraumanteils problemlos eingestellt werden. Ausgehend vom spezifischen Widerstand des Materials ohne Leerraum erhöht sich dieser beim Hinzufügen von Leerräumen. Zum Beispiel bei $TiN_{0,98}O_{0,2}$ kann der spezifische Widerstand bei 70 µΩ x cm liegen, wenn der Leerraumanteil bei 3% liegt und wächst bis auf Werte von 650 µΩ x cm, wenn der Leerraumanteil bei 40% liegt.

Sind noch zusätzliche Verbindungen, wie sie in den Patentansprüchen 2 und 4 aufgelistet sind, in dem Material vorhanden, ist es nicht notwendig, daß diese in gleichem Verhältnis in jeder Tiefe der dünnen Schicht auftreten. Dadurch wird die Anwendung als Gradientenschicht zugelassen, z. B. bei selektiven Schichten ist es erwünscht, die optischen Eigenschaften mit der Schichtdicke zu verändern. Dies ließe sich hier bequem durch Variation der chemischen Verbindungen oder durch Veränderung des Anteils an Leerräumen bewerkstelligen. Vorzugsweise verändert sich der Anteil an Leerräumen mit der Tiefe der dünnen Schicht. Es ist bevorzugt, daß die obersten 0 bis 50% der dünnen Schicht, gemessen an der Gesamtschichtdicke, aus $TiO_2$, $ZrO_2$ oder $HfO_2$ bestehen.

Dadurch bietet sich das Material für Anwendungen an, bei denen die obersten Lagen elektrische Eigenschaften besitzen sollen, z.B. bei Isolatoren.

Das erfindungsgemäße Material kann vorzugsweise als dünne Schicht auf einem metallischen Substrat aus Molybdän, Silber, Gold, Kupfer, Alumnium, Wolfram, Nickel, Chrom, Zirkonium, Titan, Hafnium, Tantal, Niob, Vanadium, Eisen und deren Legierungen aufgebracht sein. Das metallische Substrat seinerseits kann durch einen Beschichtungsprozeß auf einen beliebigen anderen festen Träger aufgebracht sein. Das metallische Substrat ist vorzugsweise eines, das durch einen Walz- oder Gußprozeß hergestellt wurde und Verunreinigungen enthält. Das als dünne Schicht ausgebildete erfindungsgemäße Material ist vorzugsweise auf eine rauhe Substratoberfläche aufgebracht, deren Rauhigkeit durch eine statistische Verteilung der Abweichungen von einem mittleren Niveau gekennzeichnet ist, und die Standardabweichung dieser Verteilung liegt im Bereich von 0 - 1500 nm, vorzugsweise 40 - 120 nm. Die Rauhigkeit ermöglicht eine bessere Absorption bei kurzen Wellenlängen und läßt dadurch eine Anwendung als Absorber-Reflektor-Tandem zu.

Das als dünne Schicht ausgebildete erfindungsgemäße Material kann weiter mit mindestens einer weiteren dünnen Schicht, bestehend aus einem oder mehreren Oxiden, vorzugsweise $SiO_2$, $ZrO_2$, $HfO_2$, $Al_2O_3$, $Y_2O_3$, beschichtet sein. Mit dieser Oxidschicht, die vorzugsweise dünner als 60 nm ist, kann das Material passiviert werden, wodurch seine Lebensdauer erhöht wird. Ein Schichtsystem aus dem erfindungsgemäßen Material mit vorzugsweise 1 - 45 Oxidschichten kann als Antireflektionsfilter eingesetzt werden. Dabei werden die Oxide und Schichtdicken des Systems mittels eines Algorithmus so gewählt, daß die Reflektion für einen Wellenlängenbereich besonders hoch wird. Entsprechende Algorithmen können der einschlägigen Literatur entnommen werden (z.B. T. Eisenhammer, M. Lazarov, N. Leutbächer, U. Schöffel und R. Sizmann, "Optimization of interference filters with genetic algorithms, applied to silver-based heat mirrows", Applied Optics, Band 32, 1993). Ein solches Schichtsystem, das auf das erfindungsgemäße Material aufgebracht ist, kann auch reflektionsvermindernd wirken sowie eine bessere Absorption für bestimmte Wellenlängen ermöglichen. Es ist bevorzugt, daß die Summe der Produkte aus Schichtdicke jeder Antireflektionsschicht multipliziert mit der Brechzahl (gemessen im sichtbaren Wellenlängenbereich) des verwendeten Oxids im Bereich von 20 - 180 nm, vorzugsweise von 80 - 110 um liegt.

Wie schon erwähnt, kann durch das Einbringen der Leerräume eine Balance zwischen verschiedenen konkurrierenden Eigenschaften, z.B. den elektrischen und metallischen eingestellt werden. Neben den optischen Eigenschaften können auch die elektrischen Eigenschaften entsprechend verändert werden. Ein spezifischer Widerstand von vorzugsweise 3500 $\mu\Omega$ x cm kommt durch einen Anteil von 20-25% (Vol.-%) an Leerräumen im Material zustande. Höhere Werte des spezifischen Widerstandes können durch höhere Leerraumanteile erreicht werden. Erst die Kontrolle der Leerräume erlaubt die kontrollierte Variation von spezifischem Widerstand und erklärt den Einfluß der Plasmafrequenzen auf die optischen Eigenschaften. Erst dies ermöglicht ein kontrolliertes Designen der Eigenschaften aus diesem Material, die dann wichtig für bestimmte Anwendungen, z.B. als selektiver Absorber, werden.

Die erfindungsgemäßen Materialien mit einstellbaren Eigenschaften, die zudem temperaturbeständig und widerstandsfähig sind finden in verschiedenen Industriezweigen Verwendung:

- In der Solarenergie: Wird das erfindungsgemäße Material mit einem Leerraum-Anteil von vorzugsweise 22 - 26 Vol.% auf vorzugsweise Kupfer, Molybdän oder Aluminium durch ein Beschichtungsverfahren vorzugsweise 40-70 nm dick aufgetragen, so entsteht ein selektiver Absorber. Dieser kann die solare Einstrahlung in Wärme mit Temperaturen bei 400 °C umwandeln, ohne daß es notwendig wird, die Strahlung zu konzentrieren. Zudem werden die Materialeigenschaften durch Steuerung der chemischen Zusammensetzung und des Leerraumanteils für eine optimale Ausbeute der solaren Strahlung in Abhängigkeit von gewünschter Temperatur der Wärmeenergie, der Meteorologe und der Konzentration angepaßt. Für die Verwendung in der Solarenergie wird das Material vorzugsweise als dünne Schicht auf eine metallische Unterlage (Metallsubstrat) beliebiger Geometrie aufgebracht, und die Schichtdicke wird vorzugsweise im Bereich von 40-80 nm gewählt, so daß die Kombination aus dünner Schicht und der metallischen Unterlage bestimmte Wellenlängen als selektiver Absorber absorbiert und die eingestrahlte Strahlung der Sonne in Wärmeenergie umwandelt. Dabei ist die Absorption von Wellenlängen des Bereichs 0,3 bis 1,5 $\mu$m bevorzugt Für die Anwendung in der Solarenergie hat das erfindungsgemäße Material einen Leerraumanteil am Volumen von vorzugsweise 20 - 30%, eine Schichtdicke von 40 - 70 nm, und als metallische Unterlage wird vorzugsweise Kupfer oder Aluminium verwendet Zusätzlich kann dabei noch eine Antireflektionsschicht aus 70 - 120 nm, vorzugsweise 85 bis 100 nm, dickem $SiO_2$ verwendet werden. Bei der Anwendung in der Solarenergie wird die Strahlungsenergie in dem Material absorbiert und dabei das Material erwärmt, und durch eine Ankopplung an einen Wärmeträger wird Wärmeenergie abgeführt. Dabei kann der Wärmeträger vorzugsweise eine oder mehrere Phasen des Wassers sein. Der Absorber kann in einen beliebigen Sonnenkollektor eingebaut werden.

- In der Halbleiterindustrie: Es ist bekannt, daß Silber und Gold durch dünne Schichten aus TiN diffundieren. Diese Diffusionsraten sind klein und schlecht kontrollierbar. Durch das erfindungsgemäße Material kann die Diffusionsrate beträchtlich erhöht und gleichzeitig die elektrischen Eigenschaften der Schicht in einem weiten Rahmen eingestellt werden. Insbesondere kann der spezifische Widerstand groß (vorzugsweise 1000-30000 $\mu\Omega$ x cm) gewählt werden. Damit können Leiterbahnen aus Silber oder Gold durch Tempern hergestellt werden.

- Als Beschichtung für den Flügel einer Lichtmühle: Wird ein dünnes wärmeisolierendes Plättchen, vorzugsweise Glimmer oder ein Aerogel mit ca. 200 bis 1000 am Kupfer, Silber oder Aluminium und danach mit vorzugsweise 40 bis 150 nm des erfindungsgemäßen Materials beschichtet, so daß ein selektiver Strahlungswandler entsteht, dann eignet sich dieses Plättchen hervorragend als Flügel in einer Lichtmühle.

- Als dekorative Schicht: Das erfindungsgemäße Material eignet sich vorzugsweise als dekorative Schicht, wenn das Material zwischen 15 und 100 um dick auf einem Substrat, vorzugsweise 30-50 um aufgebracht wird und durch Interferenzeffekte dieser Kombination ein visueller Farbeindruck vermittelt wird. Dabei kann das Material und das Substrat mit einer dünnen (ca. 60 - 120 nm), vorzugsweise teilweise transparenten Schicht bedeckt werden.

- Bei der Kraftwerkstechnik: Das erfindungsgemäße Material eignet sich weiter als selektiver Strahlungsemitter zur Umwandlung von Wärmeenergie in Strom, wobei das Material erwärmt wird und als selektiver Strahlungsemitter Wärmestrahlung freisetzt, die durch eine Fotozelle in Strom umgewandelt wird. Eine 50-500 nm dicke, vorzugsweise ca 100-200 nm dicke Schicht aus dem erfindungsgemäßen Material auf einem Substrat (vorzugsweise Molybdän), wobei das Material einen Leerraumanteil von 7-20 Vol-% hat, ist in der Kraftwerksindustrie als selektiver Emitter bevorzugt Da das erfindungsgemäße Material temperaturstabil ist, kann der Emitter auf Temperaturen über 900°C erhitzt werden.

- In der Medizin: Der Wechsel zwischen dielektrischen und metallischen Eigenschaften findet auf einer Skala im nm-Bereich statt. Es ist bekannt, daß Metalle, wie z.B. Silber, anti-mikrobiell wirken, gleichzeitig jedoch haften Bakterien auf Metallen leicht und bilden, weil sie dort sterben, einen Film. Auf diesem wiederum können sich neue Keime ansetzen, welche nicht abgetötet werden, da sie keine Berührung mit dem Metall haben. Dielektrische Materialien haben keimabstoßende Eigenschaften. Da das erfindungsgemäße Material sowohl antimikrobielle (metallische) als auch keimabstoßende (dielektrische) Eigenschaften besitzt, werden Bakterien abgetötet, bleiben aber nicht haften. Die antimikrobielle Wirkung bleibt erhalten.

Dieses weite Feld an Applikationen ist durch die Steuerung der physikalischen Eigenschaften mittels der Leerräume gegeben. Diese Steuerung läßt sich einfach mittels der Effektive-Medien-Theorie nach Bruggeman vorhersagen, wobei das Material als Mischung aus Leerräumen und den beteiligten Phasen angesehen wird. Wesentlicher Vorteil der Erfindung ist, daß die gewünschten optischen und elektrischen Eigenschaften nicht allein durch die chemische Zusammensetzung moduliert werden, sondern zusätzlich durch die Leerräume. Dadurch können wichtige Eigenschaften, wie Haftfestigkeit, Temperaturstabilität, Korrosionsstabilität etc. erhalten bleiben, die wesentlich durch die Chemie bestimmt werden.

Weitere Vorteile der vorliegenden Erfindung sind, daß

o die Metalle der Gruppe IV A des Periodensystems, Stickstoff und Sauerstoff sowie die daraus hergestellten Verbindungen ungiftig sind, und

o die Verbindungen von Titan, Zirkonium oder Hafnium mit Stickstoff und Sauerstoff temperaturstabil, widerstandsfähig (hart) und im Vergleich zu Metallen wie Eisen oder Kupfer leicht sind.

Weiter wird die Aufgabe der vorliegenden Erfindung durch ein Verfahren zur reaktiven Vakuumabscheidung (oder aktivierten reaktiven Vakuumabscheidung) gemäß Anspruch 11 gelöst. Erfindungsgemäß entsteht während des Abscheidens des Metalls der Gruppe IV A des Periodensystems auf einem Substrat durch Aufrechterhalten einer Gasatmosphäre, die mindestens eine der Gassorten $N_2$, $O_2$, $CH_4$ und/oder Edelgase enthält, eine Oxid-, Nitrid- oder Carbid-Verbindung. Dabei wird die Kondensation der Metallteilchen auf einem beheizbaren Substrat über den Gesamtgasdruck $P_{tot}$, die Aufdampfgeschwindigkeit $r$, die Substrattemperatur $T_{sub}$ und durch den Abstand 1 zwischen Metallquelle und Substrat so gesteuert, daß der Volumenanteil an Leerräumen 2 bis 45 Volumen-% beträgt, deren Größe im Bereich von $(0,5 \text{ nm})^3$ bis $(100 \text{ nm})^3$ liegt. Die Herstellungsparameter werden wie folgt gewählt:

- $T_{sub}$ = 20 bis 400°C,
- 1 = 0,01 bis 1,5m
- das Partialdruckverhältnis der Gase $N_2$ und $O_2$:

$$(P_{N_2}/P_{O_2}) = 1 \text{ bis } 2000,$$

- $P_{tot}$ = 2 x $10^{-5}$ hPa - 4 x $10^{-2}$ hPa und
- r = 0,01 bis 60 nm/s.

Bei dem Herstellungsverfahren ist es notwendig, die Herstellungsparameter so einzustellen, daß der Anteil an Leerräumen vorhersagbar ist. Dies kann nach folgendem Vorgehen geschehen: für Substrattemperaturen im Bereich von vorzugsweise 100 bis 220°C und einem Abstand der Verdampferquelle zu Substrat 1 im Bereich von vorzugsweise 0,5 bis 1,2m gilt:

Ein Volumenanteil von 34% an Leerräumen wird erreicht, wenn

$$K = \rho_{tot} \cdot r/l = (1 \text{ } bis \text{ } 3) \cdot 10^{-4} \frac{mBar \, nm}{sm}$$

und der Gesamtgasdruck $p_{tot}$ im Bereich von 2 x $10^{-3}$ hPa bis 2 x $10^{-2}$ hPa liegt.

Ein Volumenanteil von 20% an Leerräumen wird erreicht, wenn K im Bereich von

$$K = \rho_{tot} \cdot r/l = (0,2 \text{ } bis \text{ } 0,5) \cdot 10^{-4} \frac{mBar \, nm}{sm}$$

gewählt wird. Volumenanteile zwischen 20 und 34% können durch Wahl der Größe K nach folgender Gleichung einge-

stellt werden:

$$K = ((0,04 \; \text{bis} \; 0,2) \cdot \textit{gewünschterAnteilanLeerräumen} - 0,7) \cdot 10^{-4} \; \frac{mBar \; nm}{sm}$$

Damit hat man die Möglichkeit, sowohl mit der Rate r, mit dem Gesamtdruck $P_{tot}$ und mit dem Abstand 1 den gewünschten Leerraumanteil in dem erfindungsgemäßen Material zu erzielen.

Analog kann man für Substrattemperaturen im Bereich von vorzugsweise 250 bis 400°C und 1 im Bereich von vorzugsweise 0,5 bis 1,2m den Volumenanteil der Leerräume in der Schicht folgendermaßen steuern:
Ein Volumenanteil von z.B. 40% an Leerräumen wird erreicht wenn

$$K = (6 \; \text{bis} \; 8) \cdot 10^{-4} \; \frac{mBar \; nm}{sm}$$

und $P_{tot}$ im Bereich von $2 \times 10^{-2}$ hPa bis $4 \times 10^{-2}$ hPa liegt. Wenn K im Bereich von

$$K = (0,8 \; \text{bis} \; 1,9) \cdot 10^{-4} \; \frac{mBar \; nm}{sm}$$

gewählt wird, ist der Volumenanteil der Leerräume 20%. Um Werte zwischen 20 und 40% Volumenanteile zu realisieren, muß K nach der Gleichung:

$$K = ((0,12 \; \text{bis} \; 0,31) \cdot \textit{gewünschterAnteilanLeerräumen} - 0,4) \cdot 10^{-4} \; \frac{mBar \; nm}{sm}$$

gewählt werden. Dazwischen liegende Volumenanteile können durch jeweils lineare Interpolation ermittelt werden. Kleine Volumenanteile an Leerräumen (2-20%) werden bei kleinen Geschwindigkeiten von 0,01-0,1 nm/s und bei niedrigen Gasdrücken von $10^{-4}$ - $2 \times 10^{-4}$ mBar erreicht Sehr große Leeraumanteile (>40%) werden bei hohen Totalgasdrücke von $> 4 \times 10^{-2}$ mBar erreicht Bei diesen Gasdrücken kann das Material als lockerer Verbund vorliegen. Erfindungsgemäß wird die Schicht auf einem Substrat vorzugsweise aus Molybdän, Silber, Gold, Kupfer, Aluminium, Wolfram, Nickel, Chrom, Zirkonium, Titan, Hafnium, Tantal, Niob, Vanadium, Eisen oder dessen Legierungen aufgebracht. Um das Material als Block ohne Unterlage herzustellen, eignen sich folgende zwei Wege:

- Die (PVD)-Abscheidung erfolgt auf NaCl, KBr oder auf anderen Salzen in beliebiger Dicke. Danach wird das Salz in Wasser aufgelöst und das erfindungsgemäße Material bleibt übrig.
- Die Abscheidung erfolgt auf dünnen niederschmelzenden Metallen wie Kupfer, Aluminium, Zinn, Zink oder Messing. Danach werden das Material und das Substrat (Unterlage) im Hochvakuum ($10^{-10}$) erhitzt, und zwar auf Temperaturen um den Schmelzpunkt des Metalls, so daß die metallische Unterlage verdampft. Übrig bleibt das erfindungsgemäße Material.

Die Schichtdicke ist beliebig, vorzugsweise 30 bis 120 Nanometer. Vorzugsweise kann die Gasatmosphäre auch $H_2O$ und flüchtige Verbindungen des Kohlenstoffs enthalten. Dadurch kann das Herstellungsverfahren billiger gestaltet werden. In manchen Fällen ist es denkbar, Sauerstoff ganz durch Wasser zu ersetzen oder Luft einzulassen.

Beim erfindungsgemäßen Verfahren wird in einer Vakuumbeschichrungskammer ein Metall der Gruppe IV A des Periodensystems mittels Verdampfung auf einem Substrat abgeschieden, welches sich im Mittel 0,01 bis 1,5 m vom Verdampfungstiegel befindet. Über ein oder mehrere Gasdosierventile oder Gasflußmesser und Messung sowie Regelung der Partialdrücke mit einem Massenspektrometer wird eine Gasatmosphäre aufrechterhalten. Die Gasatmosphäre enthält mindestens eine der Gassorten $N_2$, $O_2$, $CH_4$ und Edelgase. Über eine Substratheizung wird über einen Regler, vorzugsweise einen PiD-Regler, die Substrattemperatur im Bereich von 20-400 °C eingeregelt. Die Aufdampfgeschwindigkeit wird über einen Schwingquarz gemessen, und dessen Signal steuert über einen Regler, vorzugsweise einen PiD-Regler, die Leistung des Verdampfers. Die gewünschte Aufdampfgeschwindigkeit wird eingestellt. Mit der Vorrichtung werden die oben angegebenen Beschichtungsparameter realisiert. Zusätzlich wird mit einem Totalgasdruckmesser der Gesamtgasdruck bestimmt. Zur Verdampfung wird ein Elektronenstrahlverdampfer und/oder ein Widerstandsverdampfer und/oder ein Induktivverdampfer eingesetzt. Durch den Einsatz eines Widerstands -oder Induktivverdampfers wird die erfindungsgemäße Vorrichtung billiger. Das Substrat wird vorzugsweise über eine Strahlungsheizung auf die notwendige Substrattemperatur von 20 bis 400°C erwärmt und geregelt Geeignet ist auch eine induktive Heizung oder eine elektrische Widerstandsheizung.

Das Verdampfen des Metalls geschieht vorzugsweise in einer separat evakuierbaren Kammer, und diese Kammer ist durch eine Blende mit einer Kammer verbunden, welche die Gasatmosphäre und das Substrat enthält, so daß das verdampfte Metall durch diese Blende zum Substrat gelangt. Durch diese Ausführungsform wird ein höherer Gesamtdruck ermöglicht, ohne die Lebensdauer des Verdampfers zu beeinträchtigen.

Das Gemisch der Gasatmosphäre wird vorzugsweise über separate Gasdurchflußmesser oder durch ein Massenspektrometer gesteuert. Zum Messen der Größe $p_{tot}$ eignet sich zB. ein Reibungsmanometer oder ein Baratron. Mit der erfindungsgemäßen Vorrichtung sind auch Gradientenschichten zu erzeugen. Bei diesen Schichten ändert sich die Zusammensetzung mit der Schichtdicke. Diese kann durch die Zusammensetzung der zugeführten Gase gesteuert werden. Bei einer Zunahme von $N_2$ kommt es zu Schichten, die mehr Stickstoff enthalten. Die Gaszusammensetzung kann über den Zufluß oder über die Messung der Partialdrücke geregelt werden. Setzt man ein Reibungsmanometer ein, können mit der erfindungsgemäßen Vorrichtung reproduzierbare Schichteigenschaften hergestellt werden.

Ist das Substrat ein Band oder eine Folie, welche gemäß der $\cos^n$-Cha rakteristik (mit n = 1 bis 7) des Verdampfers geformt ist, so daß es bzw. sie sich der Verdampfercharakteristik des Verdampfen anpaßt, wird eine gleichmäßige Beschichtung auf der gesamten Fläche sichergestellt.

Vorzugsweise ist die Beschichtungskammer durch eine separat evakuierbare Vakuumdurchführung mit einer oder mehreren anderen Beschichtungskammern verbunden, und das Substrat wird, ohne das Vakuum zu brechen, von einer zur anderen Kammer geführt, wo es in jeder Kammer einem separaten Beschichtungsprozeß unterzogen wird und dadurch Mehrschichtsysteme hergestellt werden.

Die Erfindung wird nun anhand der Figuren 1 bis 9 beschrieben.

Figur 1      zeigt den Imaginärteil der Brechzahl bei 10 µm als Funktion des Leerraumanteils für $TiN_xO_y$ (Kreuze) und $ZrN_xO_y$ (Dreiecke) [mit x = 0,7 - 0,9; y = 0,3 - 0,6]

Figur 2      zeigt den solaren Absorptionsgrad eines 55nm dicken $TiN_xO_y$-Cu Absorbers als Funktion des Leerraumanteils. [mit x = 0,7 - 0,9; y = 0,3 - 0,6]

Figur 3      zeigt den hermischen Emissionsgrad bei 250 °C eines 55 am dicken $TiN_xO_y$-Cu Absorbers als Funktion des Leerraumanteils. [mit x = 0,7 - 0,9; y = 0,3 - 0,6]

Figur 4      zeigt die Elementzusammensetzung bezogen auf Titan als Funktion des Sauerstoffpartialdrucks in der Schicht bei $TiN_xO_y$ [mit x = 0,7 - 0,9; y = 0,3 - 0,6]

Figur 5      zeigt den Quotienten aus Schichtmassendichte zu Bulkdichte als Funktion des Leerraumanteils bei $TiN_xO_y$ (Kreuze) und $ZrN_xO_y$ (Dreiecke). [mit x = 0,7 - 0,9; y = 0,3 - 0,6]

Figur 6      zeigt den Realteil der Brechzahl als Funktion der Wellenlänge bei verschiedenen Leerraumanteilen bei $TiN_xO_y$-Schichten. [mit x = 0,7 - 0,9; y = 0,3 - 0,6]

Figur 7      zeigt den Imaginärteil der Brechzahl als Funktion der Wellenlänge für verschiedene Leerraumanteile bei $TiN_xO_y$-Schichten. [mit x = 0,7 - 0,9; y = 0,3 - 0,6]

Figur 8      zeigt einen Schnitt durch einen selektiven Solarabsorber, worin das erfindungsgemäße Material eingesetzt wird.

Figur 9      zeigt einen Schnitt durch die Herstellungsvorrichtung.

Beispiel 1

In einer Hochvakuumanlage wurde Titan und Zirkonium mittels eines Elektronenstrahlverdampfers in einem Gasgemisch aus Stickstoff und Sauerstoff verdampft. Der Stickstoffpartialdruck betrug 2,5 bis 9,5 x $10^{-4}$ mBar, und der Sauerstoffpartialdruck wurde im Bereich von 1 x $10^{-8}$mBar bis 8 x $10^{-5}$mBar variiert. Bedampft wurden 2mm dicke Kupferscheiben und 1mm dicke Glasscheiben. Während des Prozesses wurden diese Substrate auf 170°C gehalten. Über eine Flächenelektrode wurde im Rezepienten eine Plasmaentladung gezündet. Dies erhöht die Bereitschaft zur Bildung von TiN und TiO bzw. ZrN und ZrO in der Schicht. Zur Analyse wurden Proben verschiedener Schichtdicke (30 bis 120 Nanometer) und Leerraumanteile (5 - 32 Volumen%) hergestellt. Dabei wurden das Partialdruckverhältnis von $N_2$ zu $O_2$ bei 35 gehalten, und der Abstand des Substrats vom Verdampfer war 0,8 m. Der Anteil an Leerräumen wird über die Anfdampfgeschwindigkeit gesteuert, die folgende Werte annahm: 0,06 nm/s für kleine Leerraumanteile und bis 0,2 nm/s für hohe Leerraumanteile.

Mittels Röntgenreflektometrie wurden die kristallinen Phasen TiN und TiO bzw. ZrN, ZrO identifiziert Die Elementzusammensetzung wurde mittels Elastic Record Detection (ERD) gemessen. Schichtdicke und Schichtdichte wurden mittels Grazing Incidents X-Ray Reflectometry (GIXR) bestimmt. Der Anteil an Leerräumen und deren Größenverteilung wurde durch Messung der gestreuten Röntgenstrahlung unter streifendem Einfall bestimmt.

Es zeigte sich, daß die Massendichte der Schicht gegenüber der Massendichte von massivem TiO oder TiN um den Anteil vermindert war, der durch die Leerräume ausgefüllt wurde. Für Zirkonium fanden sich Abweichungen von 3 bis 5% von dieser Regel. Der solare Absorptionsgrad $\alpha_{sol}$ wurde aus Messungen des Gerichtet-Hemisphärischen-Reflektionsgrades $\rho\,(\lambda)$ nach

$$\alpha_{sol} = \frac{\int\limits_0^\infty AM15(\lambda)(1-\rho\,(\lambda))\,d\lambda}{\int\limits_0^\infty AM15(\lambda)\,d\lambda}$$

bestimmt. Hier ist AM 15 ($\lambda$) das solare Standardspektrum AM 1,5 und Lamda die Wellenlänge der Strahlung. Der thermische Emissionsgrad wurde kalorimetrisch bei Temperaturen von 150 bis 400°C gemessen. Die optischen Konstanten wurden aus Reflektions- und Transmissionsmessungen mit der allgemein bekannten graphischen Methode bestimmt

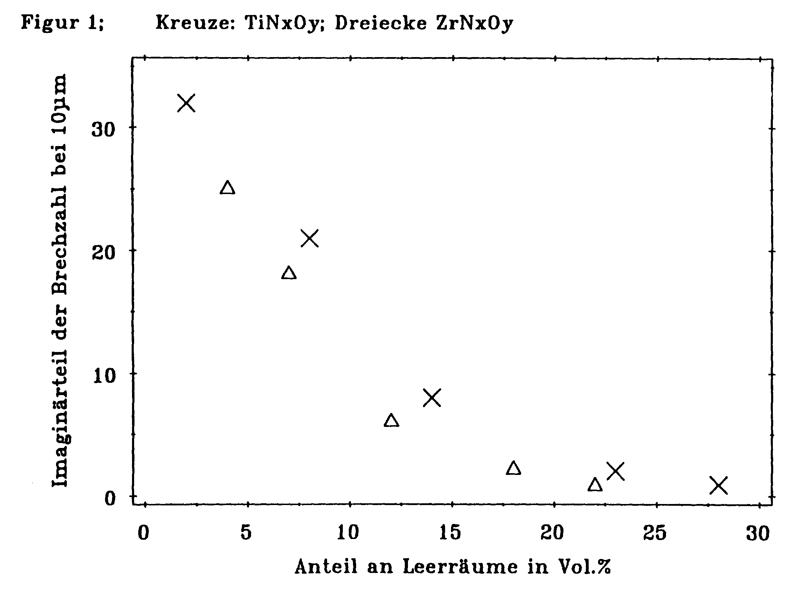

Die Ergebnisse sind in den Figuren 1 bis 7 dargestellt. Diese werden hier näher beschrieben.

Figur 1 zeigt den Imaginärteil der Brechzahl bei 10 μm als Funktion des Leerraumanteils für $TiN_xO_y$ (Kreuze) und $ZrN_xO_y$ (Dreiecke). Der Imaginärteil ohne Leerräume ist hoch, eine typisch metallische Eigenschaft. Ein Anteil von 20% bis 25% an Leerräumen bewirkt eine Mischung zwischen metallischem und dielektrischem Verhalten. Bei beiden Beispielen zeigt sich, daß ein Anteil von 20 - 30% an Leerräumen eine Senkung des Imaginärteils der Brechzahl auf moderate Werte erreichen läßt. Bei Anwendungen als selektivem Solarabsorber bedeutet dies, daß der thermische Emissionsgrad niedrig gehalten werden kann. Die Brechzahl kann ellipsometrisch oder durch Messung des Reflektions- und Transmissionsgrades bestimmt werden. Der Anteil an Leerräumen und deren Größe wurde durch Röntgenstreuung bzw. Neutronenstreuung gemessen.

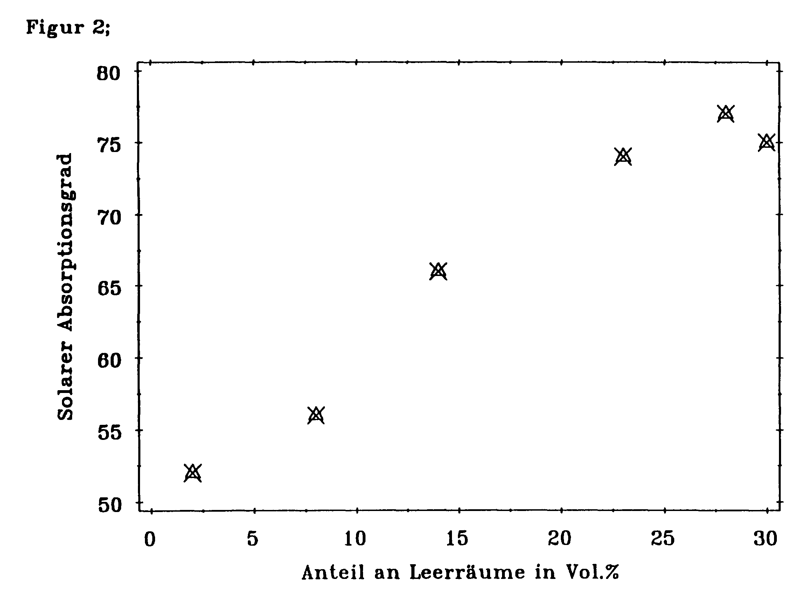

Figur 2 zeigt den solaren Absorptionsgrad eines 55 Nanometer dicken $TiN_xO_y$-Cu Absorbers als Funktion des Leerraumanteils. Durch Messung des spektralen Reflektionsgrades des Absorbers und Faltung mit dem Spektrum der solaren Einstrahlung auf der Erde wurde der Anteil an absorbierter Energie, der solare Absorptionsgrad bestimmt. Einen maximalen Absorptionsgrad der solaren Einstrahlung bewirkt ein Material, dessen Leerraumanteil 27,5%, beträgt.

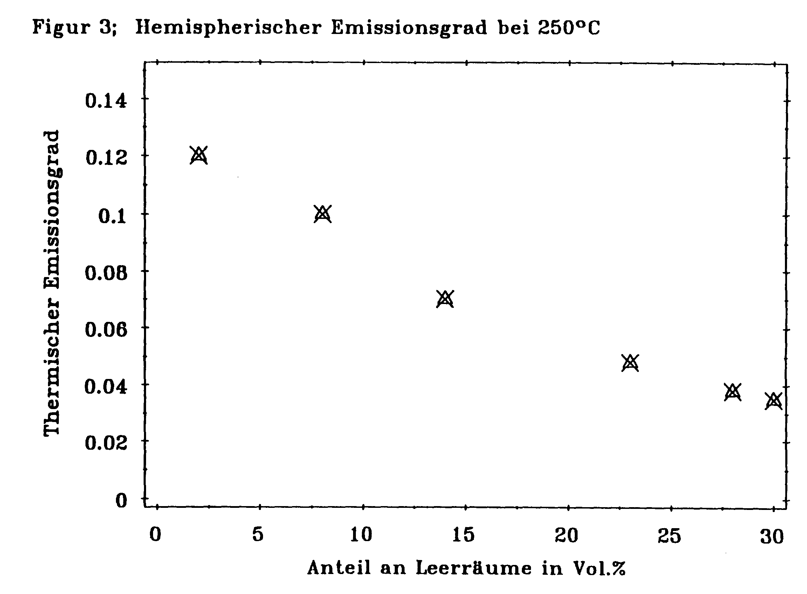

Figur 3 zeigt den thermischen Emissionsgrad bei 250°C eines 55 Nanometer dicken $TiN_xO_y$-Cu Absorbers als Funktion des Leerraumanteils. Der thermische Emissionsgrad nimmt mit zunehmendem Leerraumanteil ab, was durch die Abnahme der metallischen Eigenschaften erklärt werden kann. Um den thermischen Emissionsgrad zu messen, muß die Probe im Vakuum auf die Meßtemperatur, im vorliegenden Beispiel 250°C, gebracht werden. Durch einen geeigneten Aufbau wird erreicht, daß die Probe nur durch Strahlung Wärme verliert. Aus der Energiebilanz wurde der Emissionsgrad berechnet.

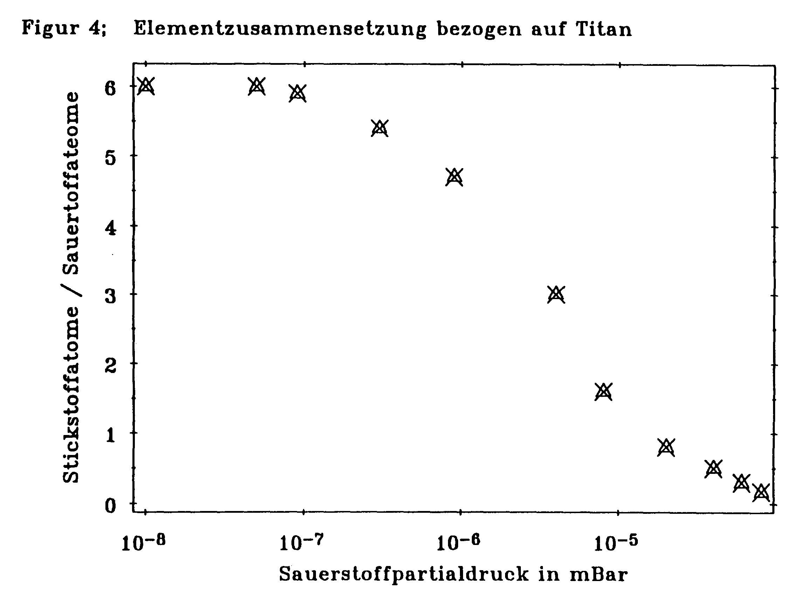

Figur 4 zeigt die Elementzusammensetzung bezogen auf Titan als Funktion des Sauerstoffpartialdrucks in der Schicht bei $TiN_xO_y$. Das Verhältnis von Stickstoff zu Sauerstoff wurde in der erfindungsgemäßen Vorrichtung zur Herstellung des erfindungsgemäßen Materials im Bereich von 1 bis 2000 gesteuert. Dabei wurden die für Anwendungen als selektiver Absorber in der Solarenergie geforderten chemischen Eigenschaften wie zB. hohe Haftfestigkeit, durch einen niedrigen Sauerstoffpartialdruck erreicht.

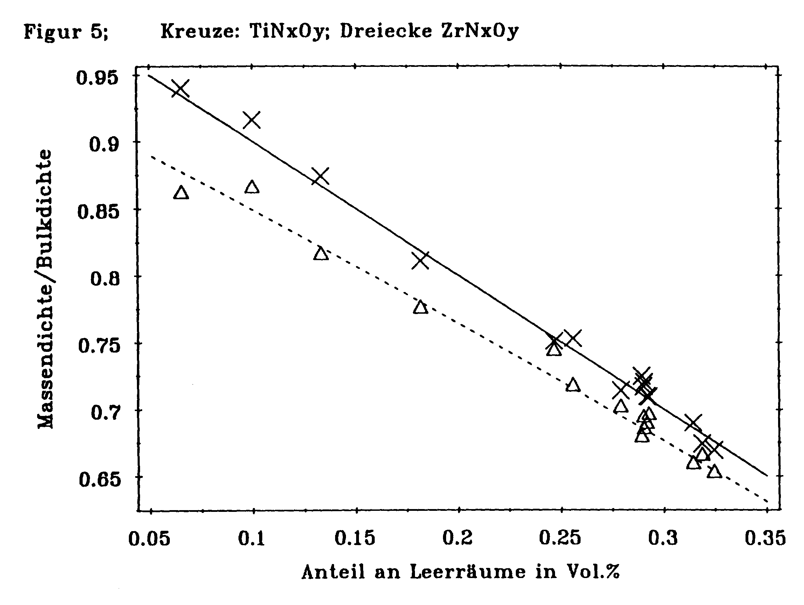

Figur 5 zeigt den Quotienten aus Schichtmassendichte zu Bulkdichte als Funktion des Leerraumanteils bei $TiN_xO_y$ (Kreuze) und $ZrN_xO_y$ (Dreiecke). Es zeigt sich, daß die Massendichte durch den Leerraumanteil gesteuert wird.

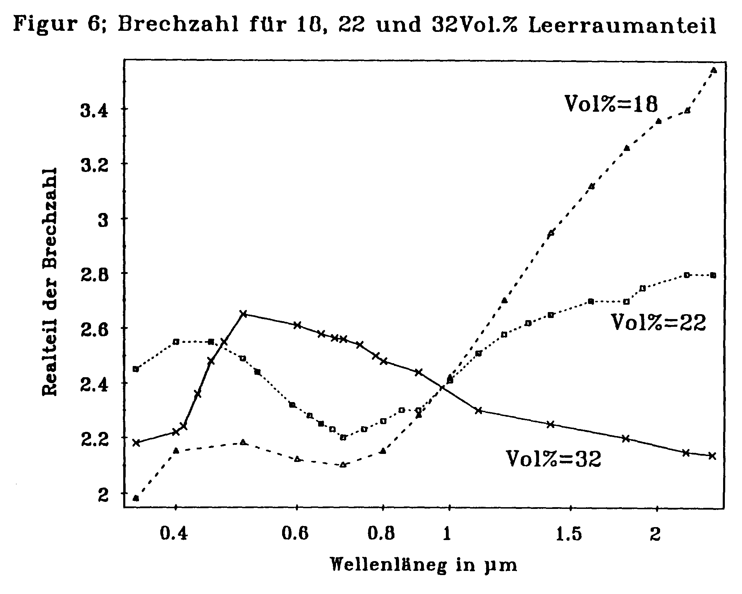

Figur 6 zeigt den Realteil der Brechzahl als Funktion der Wellenlänge bei verschiedenen Leerraumanteilen bei $TiN_xO_y$ Schichten. Bei einem Leerraumanteil von 18 Volumen-% zeigt der Realteil der Brechzahl noch metallische Eigenschaften, und steigt mit der Wellenlänge an. Bei einem Anteil von 22 Volumen-% dominieren weder metallische noch dielektrische Eigenschaften und bei 32 Volumen-% ist das Material im wesentlichen dielektrisch.

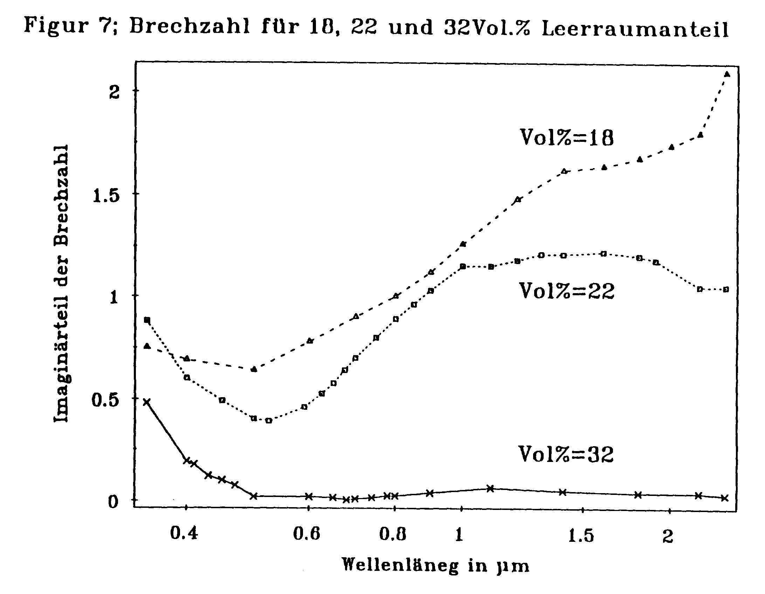

Figur 7 zeigt den Imaginärteil der Brechzahl als Funktion der Wellenlänge bei verschiedenen Leerraumanteilen bei $TiN_xO_y$ Schichten. Bei einem Leerraumanteil von 18 Volumen-% zeigt der Imaginärteil der Brechzahl noch metallische Eigenschaften und steigt mit der Wellenlänge an. Bei einem Anteil von 22 Volumen-% dominieren weder metallische noch dielektrische Eigenschaften, und bei 32 Volumen-% ist das Material in weiten Bereichen der Wellenlänge dielektrisch.

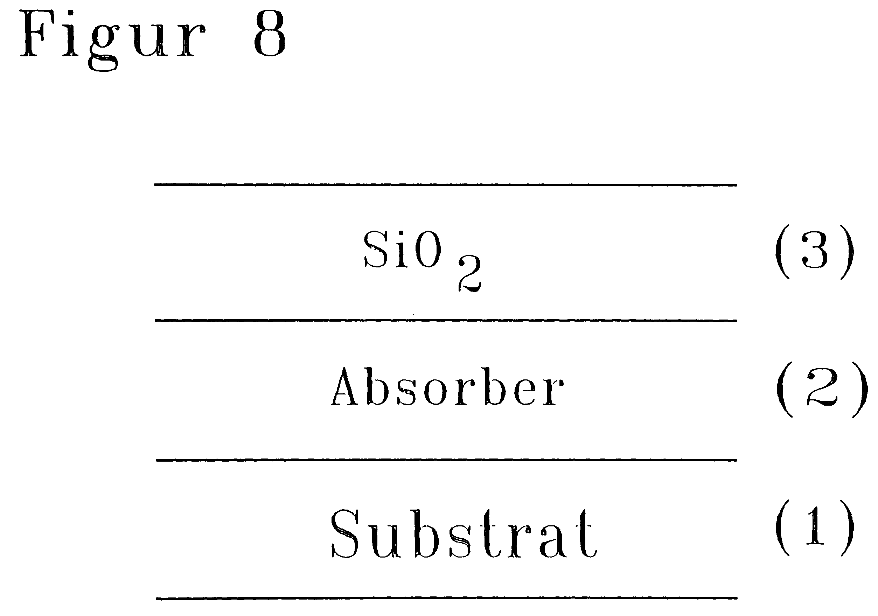

Eine Anwendung des erfindungsgemäßen Materials wird in Fig. 8 gezeigt. Dabei zeigt Figur 8 einen Schnitt durch einen selektiven Solarabsorber, worin das erfindungsgemäße Material (2) eingesetzt wird. Auf einem hoch reflektierenden Substrat (1), Kupfer, ist eine 55 Nanometer dicke Schicht aus dem erfindungsgemäßen Material (2) aufgebracht und diese wiederum mit einer 92 Nanometer dicken Antireflektionsschicht aus $SiO_2$ (3) bedeckt. Durch die Antireflektionsschicht wird der solare Absorptionsgrad von 0,8 auf 0,94 erhöht. Bei dem erfindungsgemäßen Material (2) handelt es sich um eines, das durch einen Leerraumanteil von 27,5 Volumen-% und ein Verhältnis von Titan:Stickstoff:Sauerstoff von 1 : 0,92 : 0,35 gekennzeichnet ist.

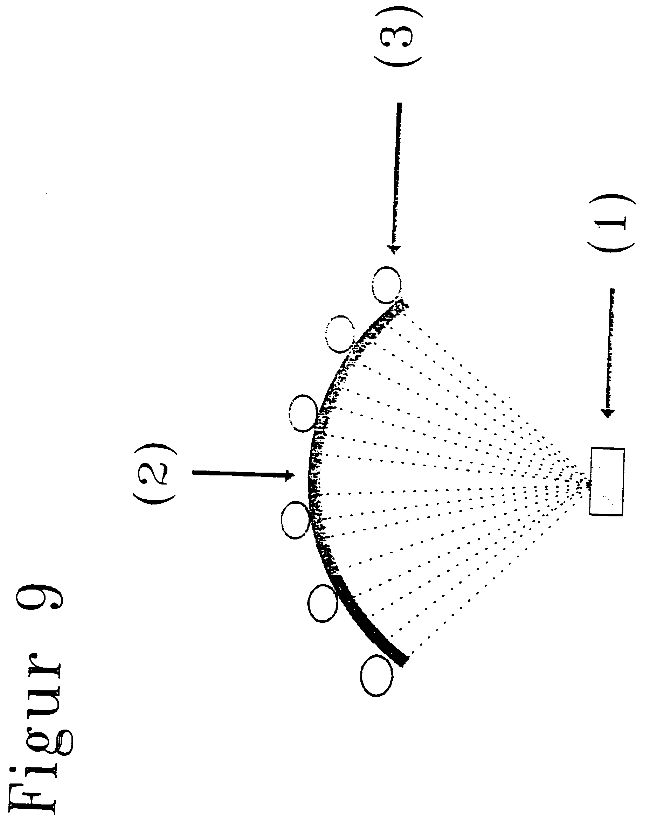

Figur 9 zeigt einen Schnitt durch eine Vorrichtung zum Durchführen des erfindungsgemäßen Herstellungs verfahrens. Über einen Elektronenstrahlverdampfer (1) wird ein Kupferband (2) geführt. Dies wird durch Rollen (3) derart in einer gekrümmten Form gehalten, daß die Beschichtung gleichmäßig ist. Die Krümmung folgt der Charakteristik des Verdampfers, welche von der eines Lambertstrahlers abweichen kann. Während die Charakteristik eines Lambertstrahlers durch das "Cosinus[1]-Gesetz " beschrieben werden kann, muß bei einem Elektronenstrahlverdampfer eine Modifikation des Gesetzes berücksichtigt werden, d. h. es wird eine "Cosinus[n]"-Charakteristik mit n im Bereich von 1 bis 7 befolgt.

## Patentansprüche

1. Material enthaltend chemische Verbindungen zwischen einem oder mehreren Metallen (M) der Gruppe IV A des Periodensystems, Stickstoff (N) und Sauerstoff (O)
   **dadurch gekennzeichnet**,
   daß 2 bis 45 % des Volumens durch Leerräume, deren Größe im Bereich von $(0,5 \text{ nm})^3$ bis $(100 \text{ nm})^3$ liegt, gebildet wird und das restliche Volumen eine Zusammensetzung des Metalls der Gruppe IV A des Periodensystems zu Stickstoff zu Sauerstoff von 1:(0,1 bis 1,7):(0,1 bis 1,7) aufweist, wobei ein Material mit der Formel $MN_xO_y$ (mit X, Y = 0,1 - 1,7) entsteht.

2. Material nach Patentanspruch 1, dadurch gekennzeichnet, daß das restliche Volumen eine oder mehrere der folgenden chemischen Verbindungen umfaßt:

   - $MN_x$ mit x = 0,7 bis 1,2,
   - $MO_x$ mit x = 0,7 bis 1,2,
   - Magnelli-Phasen des M-O-Systems $(M_nO_{2n-1})$,
   - $MO_2$,
   - $M_2N$,
   
   wobei M = Metall der Gruppe IV A des Periodensystems.

3. Material nach Patentanspruch 1 oder 2, dadurch gekennzeichnet, daß das Metall der Gruppe IV A des Periodensystems Titan, Zirkonium oder Hafnium oder eine Mischung von zwei oder drei dieser Metalle ist.

4. Material nach einem der vorhergehenden Patentansprüche, dadurch gekennzeichnet, daß darin auch kleine Mengen an Kohlenstoffverbindungen des Metalls enthalten sind.

5. Material nach einem der vorhergehenden Patentansprüche, dadurch gekennzeichnet, daß der Realteil der Brechzahl für die Röntgenwellenlänge von 0,0709 nm im Bereich von 0,9999984 bis 0,9999973 und die Massendichte des Materials im Bereich von 3,7 bis 4,5 $g/cm^3$ liegen.

6. Material nach einem der vorhergehenden Patentansprüche, dadurch gekennzeichnet, daß die komplexwertige Brechzahl für Wellenlängen im Bereich von 0,5 bis 4,5 $\mu m$ weder auf ein typisches metallisches Verhalten hinweist, noch ein typisches dielektrisches Verhalten anzeigt, und/oder daß der spezifische Widerstand der dünnen Schicht im Bereich von 30 bis 30000 $\mu\Omega$.cm liegt.

7. Material nach einem der vorhergehenden Patentansprüche, dadurch gekennzeichnet, daß es als dünne Schicht vorliegt, deren Schichtdicke im Bereich von 3 nm bis 3 mm, vorzugsweise 30-120 nm, liegt.

8. Material nach einem der vorhergehenden Patentansprüche, dadurch gekennzeichnet, daß die dünne Schicht auf einem metallischen Substrat beliebiger Geometrie wie Molybdän, Silber, Gold, Kupfer, Aluminium, Wolfram, Nickel, Chrom, Zirkonium, Titan, Hafnium, Tantal, Niob, Vanadium, Eisen oder deren Legierungen aufgebracht ist, wobei die dünne Schicht mit mindestens einer weiteren dünnen Schicht aus einem oder mehreren Oxiden, ausgewählt

aus $SiO_2$, $ZrO_2$, $HfO_2$, $Al_2O_3$ oder $Y_2O_3$, bevorzugterweise mit einer Antireflexionsschicht aus $SiO_2$ einer Dicke von 60-140 nm, beschichtet ist.

9. Verwendung des Materials nach einem der Patentansprüche 1 bis 8 als Absorber zur Umwandlung von Strahlungsenergie in Wärmeenergie, dadurch gekennzeichnet, daß die Kombination aus dünner Schicht und Substrat bestimmte Wellenlängen als selektiver Absorber absorbiert und die eingestrahlte Strahlung in Wärmeenergie umwandelt.

10. Verwendung nach Patentanspruch 9, dadurch gekennzeichnet, daß bei dem Material der Anteil der Leerräume am Volumen 20 bis 30% beträgt, die Schichtdicke 40 bis 70 nm ist und als metallische Unterlage Kupfer, Molybdän oder Aluminium verwendet wird.

11. Verfahren zur Herstellung von dünnen Schichten aus dem Material gemäß einem der Ansprüche 1-8 mittels reaktiver Vakuumabscheidung, dadurch gekennzeichnet, daß während des Abscheidens des Metalls der Gruppe IV A des Periodensystems durch Aufrechterhalten einer Gasatmosphäre, die mindestens eine der Gassorten $N_2$, $O_2$, $CH_4$ und Edelgase enthält, eine Oxid-, Nitrid- oder Carbid-Verbindung entsteht und die Abscheidung der Metallteilchen auf einem beheizbaren Substrat, über den Gesamtgasdruck $p_{tot}$, Aufdampfgeschwindigkeit r, Substrattempe- ratur $T_{sub}$ und Abstand zwischen Metallquelle und Substrat 1 gesteuert wird, wobei diese Parameter in den Bereichen

$T_{sub}$ = 20 bis 400°C,
1 = 0,01 bis 1,5 m,

- das Partialdruckverhältnis der Gase $N_2$ und $O_2$ : $(P_{N2}/P_{O2})$ = 1 bis 2000,
- $P_{tot}$ = $2x10^{-5}$ h Pa - $4x10^{-2}$ h Pa
- r = 0,01 bis 60 nm/s
 liegen, so daß Schichten mit einem Volumenanteil von 2 bis 45% an Leerräumen, deren Größe im Bereich von $(0,5 nm)^3$ bis $(100 nm)^3$ liegt, gebildet werden.

12. Verfahren nach Patentanspruch 11, dadurch gekennzeichnet, daß der Gasatmosphäre zusätzlich $H_2O$ und flüch- tige Verbindungen des Kohlenstoffes zugesetzt werden.

13. Verfahren nach Patentanspruch 11 oder 12, dadurch gekennzeichnet, daß in einer Vakuumbeschichtungskammer das Metall mittels Verdampfung auf einem Substrat, welches sich im Mittel 0,01 bis 1,5 m vom Verdampfungstiegel befindet, abgeschieden wird und über einen oder mehrere Gasdosierventile oder Gasflußmesser und Messung sowie Regelung der Partialdrücke mit einem Massenspektrometer eine Gasatmosphäre aufrechterhalten wird, die mindestens eine der Gassorten $N_2$, $O_2$, $CH_4$ und Edelgase enthält, wobei eine Substratheizung über einen Regler die Substrattemperatur im Bereich von 20-400°C einregelt, die Aufdampfgeschwindigkeit über einen Schwingquarz gemessen wird und dessen Signal über einen Regler auf den Verdampfer übertragen wird und somit die gewünschte Aufdampfgeschwindigkeit eingestellt wird, so daß die in Patentanspruch 11 beschriebenen Beschichtungsparameter realisiert werden, wobei zusätzlich mit einem Totalgasdruckmesser der Gesamtgasdruck bestimmt wird.

**Claims**

1. A material containing chemical compounds between one or more metals (M) of Group IV A of the Periodic System, nitrogen (N) and oxygen (O) characterized in that from 2 to 45% of the volume is formed by voids (empty spaces), the magnitude of which is in the range of from $(0.5 nm)^3$ to $(100 nm)^3$, and the remaining volume has a composition of the metal from Group IV A of the Periodic System to nitrogen to oxygen of from 1: (0.1 to 1.7) : (0.1 to 1.7), resulting in a material having the formula $MN_xO_y$ (with X, Y = 0.1 - 1.7).

2. The material according to claim 1, characterized in that the remaining volume comprises one or more of the follow- ing chemical compounds:

- $MN_x$, with x = 0.7 to 1.2,
- $MO_x$, with x = 0.7 to 1.2,
- Magnelli phases of the M-O system ($M_nO_{2n-1}$),
- $MO_2$,

- $M_2N$,
    wherein M = metal from Group IV A of the Periodic System.

3. The material according to claim 1 or 2, characterized in that the metal from Group IV A of the Periodic System is titanium, zirconium or hafnium or a mixture of two or three of these metals.

4. The material according to any of the preceding claims, characterized in that it also contains small amounts of carbon compounds of the metal.

5. The material according to any of the preceding claims, characterized in that the real part of the refractive index for the 0.0709 nm X-ray wavelength is in the range of from 0.9999984 to 0.9999973, and the mass density of the material is in the range of from 3.7 to 4.5 g/cm$^3$.

6. The material according to any of the preceding claims, characterized in that the complex-valued refractive index for wavelengths in the range of from 0.5 to 4.5 μm points to neither a typical metallic behavior nor a typical dielectric behavior, and/or that the specific resistance of the thin layer is in the range of from 30 to 30,000 μΩ cm.

7. The material according to any of the preceding claims, characterized in that it is present as a thin layer, the layer thickness of which is in the range of from 3 nm to 3 mm, preferably of from 30 to 120 nm.

8. The material according to any of the preceding claims, characterized in that the thin layer is applied onto a metallic substrate of any geometry such as molybdenum, silver, gold, copper, aluminum, tungsten, nickel, chromium, zirconium, titanium, hafnium, tantalum, niobium, vanadium, iron or their alloys, wherein the thin layer is coated with at least one further thin layer of one or more oxides selected from $SiO_2$, $ZrO_2$, $HfO_2$, $Al_2O_3$ or $Y_2O_3$, preferably with an anti-reflective layer of $SiO_2$ having a thickness of from 60 to 140 nm.

9. Use of the material according to any of claims 1 to 8 as an absorber for the conversion of radiation energy into heat energy, characterized in that the combination of thin layer and substrate absorbs certain wavelengths as selective absorber and converts the incident radiation into heat energy.

10. The use according to claim 9, characterized in that in the material the percentage of the voids constitutes from 20 to 30% of the volume, that the layer thickness is from 40 to 70 nm and that copper, molybdenum or aluminum is employed as the metallic substrate.

11. A process for producing thin layers of a material according to any of claims 1 to 8 by means of reactive vacuum deposition, characterized in that, during the deposition of the metal from Group IV A of the Periodic System by maintaining a gas atomsphere containing at least one of the gas species $N_2$, $O_2$, $CH_4$ and noble gases, an oxide, nitride or carbide compound is formed and the deposition of the metal particles onto a heatable substrate is controlled via the total gas pressure $p_{tot}$, deposition rate r, substrate temperature $T_{sub}$ and distance between metal source and substrate 1, wherein these parameters are in the ranges of

$T_{sub}$ = 20 to 400 °C,
1 = 0.01 to 1.5 m,

- the partial pressure ratio of the gases $N_2$ and $O_2$: $(P_{N2}/P_{O2})$ = 1 to 2000,
- $p_{tot}$ = $2 \times 10^{-5}$ h Pa - $4 \times 10^{-2}$ h Pa,
- r = 0.01 to 60 nm/s,
    such that layers with a volume percentage of voids of from 2 to 45% are formed, the magnitude of which is in the range of from $(0.5 \text{ nm})^3$ to $(100 \text{ nm})^3$.

12. The process according to claim 11, characterized in that $H_2O$ and volatile compounds of carbon are additionally added to the gas atmosphere.

13. The process according to claim 11 or 12, characterized in that the metal is deposited by evaporation in a vacuum deposition chamber onto a substrate positioned on the average from 0.01 to 1.5 m from the evaporation crucible, and a gas atmosphere is maintained by means of one or more gas dosing valves or gas flow meters and measurement as well as control of the partial pressures with a mass spectrometer, which gas atmosphere contains at least one of the gas species $N_2$, $O_2$, $CH_4$ and noble gases, wherein a substrate heating controls the substrate tempera-

# EP 0 736 109 B1

ture by means of a controller in the range of from 20-400 °C, the deposition rate is measured by means of a quartz oscillator and the signal from the same is transmitted via a controller to the evaporator, the desired deposition rate thus being adjusted, such that the coating parameters described in claim 11 result, wherein the overall gas pressure is additionally determined with a total gas pressure meter.

## Revendications

1. Matériau contenant des composés chimiques d'un ou plusieurs métaux (M) du Groupe IV A du Tableau Périodique, de l'azote (N) et de l'oxygène (O), caractérisé en ce que 2 à 45 % du volume sont constitués d'espaces vides dont la taille est comprise entre 0,5 mn$^3$ et 100 nm$^3$, le volume restant présentant une proportion métal du Groupe IV A du Tableau Périodique : azote : oxygène de 1:(0,1 à 1,7) : (0,1 à 1,7), avec formation d'un matériau $MN_xO_y$ (avec X, Y = 0,1-1,7).

2. Matériau selon la revendication 1, caractérisé en ce que le volume restant contient un ou plusieurs des composés chimiques suivants :

   - $MN_x$, avec x = 0,7 à 1,2,
   - $MO_x$, avec x = 0,7 à 1,2,
   - des phases de Magnelli du système M-O ($M_nO_{2n-1}$),
   - $MO_2$,
     où M est un métal du Groupe IV A du Tableau Périodique.

3. Matériau selon la revendication 1 ou 2, caractérisé en ce que le métal du Groupe IV A du Tableau Périodique est le titane, le zirconium ou le hafnium, ou un mélange de deux ou trois de ces métaux.

4. Matériau selon l'une des revendications précédentes, caractérisé en ce qu'il contient aussi de petites quantités de composés carbonés du métal.

5. Matériau selon l'une des revendications précédentes, caractérisé en ce que la partie réelle de l'indice de réfraction, pour la longueur d'onde des rayons X de 0,0709 nm, est comprise entre 0,9999984 et 0,9999973, et la masse volumique du matériau est comprise entre 3,7 et 4,5 g/cm$^3$.

6. Matériau selon l'une des revendications précédentes, caractérisé en ce que l'indice de réfraction complexe, pour des longueurs d'ondes comprises entre 0,5 et 4,5 μm, n'est le signe ni d'un comportement métallique représentatif, ni d'un comportement diélectrique représentatif, et/ou que la résistance spécifique de la couche mince est comprise entre 30 et 30 000 μΩ.cm.

7. Matériau selon l'une des revendications précédentes, caractérisé en ce qu'il se présente sous tortue d'une couche mince dont l'épaisseur de couche est comprise entre 3 nm et 3 mm, de préférence entre 30 et 120 nm.

8. Matériau selon l'une des revendications précédentes, caractérisé en ce que la couche mince est appliquée sur un substrat métallique ayant une géométrie quelconque, constitué de molybdène, d'argent, d'or, de cuivre, d'aluminium, de tungstène, de nickel, de chrome, de zirconium, de titane, de hafnium, de tantale, de niobium, de vanadium, de fer ou de leurs alliages, la couche mince étant revêtue d'au moins une autre couche mince constituée d'un ou plusieurs oxydes choisis parmi $SiO_2$, $ZrO_2$, $HfO_2$, $Al_2O_3$ ou $Y_2O_3$, de préférence d'une couche antiréfléchissante constituée de $SiO_2$ et ayant une épaisseur de 60 à 140 nm.

9. Utilisation du matériau selon l'une des revendications 1 à 8 en tant qu'absorbant pour convertir une énergie rayonnante en énergie thermique, caractérisée en ce que la combinaison d'une couche mince et d'un substrat absorbe certaines longueurs d'ondes en tant qu'absorbant sélectif, et convertit le rayonnement arrivant en énergie thermique.

10. Utilisation selon la revendication 9, caractérisée en ce que, dans le matériau, la proportion des espaces vides est de 20 à 30 % par rapport au volume, l'épaisseur de couche est de 40 à 70 nm, et on utilise en tant que support métallique du cuivre, du molybdène ou de l'aluminium.

11. Procédé de fabrication de couches minces en le matériau selon l'une des revendications 1 à 8, par déposition réactive sous vide, caractérisé en ce que, pendant la déposition du métal du Groupe IV A du Tableau Périodique, et tout

**13**

en maintenant une atmosphère gazeuse Contenant au moins l'un des types de gaz $NO_2$, $O_2$, $CH_4$ et les gaz rares, il se forme un composé oxyde, nitrure ou carbure, et la déposition des particules métalliques sur le substrat chauffable est régulée en fonction de la pression gazeuse totale $P_{tot}$, de la vitesse de métallisation r, de la température du substrat $T_{sub}$ et de la distance entre la source métallique et le substrat 1, ces paramètres étant compris dans les intervalles suivants :

$T_{sub}$ = 20 à 400°C,
l = 0,01 à 1,5 m,

- rapport entre les pressions partielles des gaz $N_2$ et $O_2$ est ($P_{N2}/P_{O2}$) = 1 à 2000,
- $P_{tot}$ = 2.10$^{-5}$ hPa - 4.10$^{-2}$ hPa,
- r = 0,01 à 60 nm/s,
  de façon qu'il se forme des couches dont les espaces vides représentent 2 à 45 % en volume, espaces vides dont la taille est comprise entre 0,5 nm$^3$ et 100 nm$^3$.

12. Procédé selon la revendication 11, caractérisé en ce qu'on ajoute encore à l'atmosphère gazeuse du $H_2O$ et des composés volatils du carbone.

13. Procédé selon la revendication 11 ou 12, caractérisé en ce que, dans une chambre de métallisation sous vide, le métal est déposé par évaporation sur un substrat se trouvant en moyenne à une distance de 0,01 à 1,5 m du creuset de vaporisation, et, par l'intermédiaire d'une ou plusieurs buses doseuses de gaz ou débitmètres de gaz, et grâce à une mesure ainsi qu'à une régulation des pressions partielles à l'aide d'un spectromètre de masse, on maintient une atmosphère gazeuse qui contient au moins l'un des types de gaz $N_2$, $O_2$, $CH_4$ et les gaz rares, auquel cas un chauffage du substrat assure, par l'intermédiaire d'un régulateur, une régulation de la température du substrat entre 20 et 400°C, on mesure la vitesse de métallisation à l'aide d'un quartz oscillant, et on transfère son signal à l'évaporateur par l'intermédiaire d'un régulateur, ce signal étant ainsi ajusté à la vitesse souhaitée de métallisation, de façon à réaliser les paramètres de revêtement décrits dans la revendication 11, ce à l'occasion de quoi on détermine en outre la pression gazeuse totale à l'aide d'un manomètre de pression gazeuse totale.

Figur 1:    Kreuze: TiNxOy; Dreiecke ZrNxOy

Figur 2:

## Figur 3; Hemispherischer Emissionsgrad bei 250°C

EP 0 736 109 B1

Figur 4: Elementzusammensetzung bezogen auf Titan

Figur 5;    Kreuze: TiNxOy; Dreiecke ZrNxOy

EP 0 736 109 B1

Figur 6: Brechzahl für 18, 22 und 32Vol.% Leerraumanteil

Figur 7: Brechzahl für 18, 22 und 32Vol.% Leerraumanteil

Figur 8

SiO$_2$ (3)

Absorber (2)

Substrat (1)

# Figur 9

EP 0 736 109 B1